(19) **Europäisches Patentamt European Patent Office Office européen des brevets**

(11) **EP 4 231 024 B1**

(12) **EUROPEAN PATENT SPECIFICATION**

(45) Date of publication and mention of the grant of the patent:
**05.03.2025 Bulletin 2025/10**

(21) Application number: **21898680.0**

(22) Date of filing: **26.11.2021**

(51) International Patent Classification (IPC):
**G01R 22/06** $^{(2006.01)}$   **G01R 21/06** $^{(2006.01)}$
**G01R 19/00** $^{(2006.01)}$   **G01R 19/10** $^{(2006.01)}$
**G01R 19/30** $^{(2006.01)}$   **G01R 1/30** $^{(2006.01)}$
**H03F 1/02** $^{(2006.01)}$

(52) Cooperative Patent Classification (CPC):
**G01R 29/0878; G01R 29/0892; H03F 1/0288; H03F 3/189; H03F 3/24;** G01R 21/06; H03F 2200/451

(86) International application number:
**PCT/KR2021/017651**

(87) International publication number:
**WO 2022/114855 (02.06.2022 Gazette 2022/22)**

(54) **APPARATUS AND METHOD FOR MEASURING STRENGTH OF SIGNAL**

VORRICHTUNG UND VERFAHREN ZUR MESSUNG DER STÄRKE EINES SIGNALS

APPAREIL ET PROCÉDÉ DE MESURE DE PUISSANCE DE SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.11.2020 KR 20200161616**

(43) Date of publication of application:
**23.08.2023 Bulletin 2023/34**

(73) Proprietor: **Samsung Electronics Co., Ltd.**
**Suwon-si, Gyeonggi-do 16677 (KR)**

(72) Inventors:
 • **KIM, Kihyun**
  **Suwon-si Gyeonggi-do 16677 (KR)**
 • **KIM, Seokhyeon**
  **Suwon-si Gyeonggi-do 16677 (KR)**
 • **KIM, Yonghoon**
  **Suwon-si Gyeonggi-do 16677 (KR)**
 • **PARK, Hyunchul**
  **Suwon-si Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(56) References cited:
 JP-A- 2008 035 487       KR-A- 20140 053 089
 KR-A- 20150 042 470      KR-B1- 100 680 211
 KR-B1- 100 680 211       US-A1- 2015 071 335
 US-A1- 2015 116 039

## Description

### [Technical Field]

The disclosure relates, in general, to a wireless communication system, and in particular, to a method and apparatus for measuring strength of a signal in the wireless communication system.

### [Background Art]

To meet a demand on wireless data traffic which has been in an increasing trend after a 4th Generation (4G) communication system was commercialized, there is an ongoing effort to develop an improved 5th Generation (5G) communication system or a pre-5G communication system. For this reason, the 5G communication system or the pre-5G communication system is called a beyond 4G network communication system or a post Long Term Evolution (LTE) system.

To achieve a high data transfer rate, the 5G communication system is considered to be implemented in an ultra-high frequency band. To reduce a propagation path loss at the ultra-high frequency band and to increase a propagation delivery distance, beamforming, massive Multiple Input Multiple Output (MIMO), full dimensional MIMO (FD-MIMO), array antenna, analog beam-forming, and large scale antenna techniques are under discussion in the 5G communication system.

In addition, to improve a network of a system, techniques such as an evolved small cell, an advanced small cell, a cloud Radio Access Network (RAN), an ultra-dense network, Device to Device (D2D) communication, a wireless backhaul, a moving network, cooperative communication, Coordinated Multi-Points (CoMP), and reception interference cancellation, or the like are being developed in the 5G communication system.

In addition thereto, hybrid Frequency shift keying and Quadrature Amplitude Modulation (FQAM) and Sliding Window Superposition Coding (SWSC) as an Advanced Coding Modulation (ACM) technique and Filter Bank Multi Carrier (FBMC), Non Orthogonal Multiple Access (NOMA), and Sparse Code Multiple Access (SCMA), or the like as an advanced access technology are being developed in the 5G system.

A beamforming technique may be used when using a signal of a millimeter wave (mmWave) band in the wireless communication system. An electronic device performing beamforming may require a plurality of antenna elements, and may require a plurality of Radio Frequency (RF) chains as paths through which signals transmitted or received by the plurality of antenna elements pass. In this case, in order to use the plurality of antenna elements and the plurality of RF chains, the electronic device may need to minimize power consumption. Accordingly, in order to measure power consumed by the signals transmitted or received by the plurality of antenna elements through the plurality of RF chains, there is a need to measure power consumption for each RF chain. However, even if power consumed in the RF chain due to signal transmission or reception is identical, a change in impedance of an antenna for transmitting or receiving the signal may cause a change in a voltage of the signal. That is, it may be inaccurate to measure the power consumed in the RF change through the voltage of the signal passing through the RF chain. Accordingly, in order to minimize an error of power measurement, it is required to measure signal strength in a more effective manner by considering the signal voltage which changes depending on the change in the antenna impedance.

KR 100680211 B1 discloses a mobile communication terminal comprising an RF power amplifier; an arrangement for measuring power out of the amplifier comprises a lambda/4 transmission line, with power being sensed at both ends of the line; to measure forward power only, cancelling reflected power due to load impedance/antenna mismatch. US 2015/0116039 A1 discloses adaptive adjustment of a power splitter in a Doherty amplifier.

### [Disclosure of Invention]

### [Technical Problem]

Based on the aforementioned discussion, the disclosure provides a method and apparatus in which a transmission line having a specific length is used to accurately measure power of a signal passing through the transmission line in a wireless communication system.

In addition, the disclosure provides a structure capable of accurately measuring signal power by arranging a transmission line without having to use an additional device in the wireless communication system.

### [Solution to Problem]

The present invention is defined by the appended set of claims.

According to various embodiments of the disclosure, a method of measuring power of a signal may include obtaining, by at least one sensor, a first voltage of the signal at a first point between a power amplifier and a transmission line, obtaining, by the at least one sensor, a second voltage of the signal at a second point between the transmission line and an antenna, and calculating power, based on the first voltage and the second voltage. A length of the transmission line may be associated with a wavelength of the signal.

According to various embodiments of the disclosure, an electronic device of a wireless communication system may include a power amplifier, an antenna, a transmission line, at least one sensor, and at least one processor electrically coupled to the at least one sensor. The at least one sensor may be configured to obtain a first voltage of a signal at a first point between the power amplifier and the transmission line, and obtain a second voltage of the signal at a second point between the transmission line and the antenna. The at least one processor may be configured to calculate power, based on the first voltage and second voltage obtained by the at least one sensor. A length of the transmission line may be associated with a wavelength of the signal.

According to various embodiments of the disclosure, an electronic device of a wireless communication system may include a plurality of Radio Frequency (RF) chains, a plurality of antennas corresponding to the plurality of RF chains, a transmission line, at least one sensor, and at least one processor electrically coupled to the at least one sensor. Among the plurality of RF chains, at least one RF chain may include a power amplifier. The transmission line may be disposed between the power amplifier and at least one antenna corresponding to the power amplifier. The at least one sensor may be configured to obtain a first voltage of a signal at a first point between the power amplifier and the transmission line, and obtain a second voltage of the signal at a second point between the at least one antenna and the transmission line. The at least one processor may be configured to calculate power, based on the first voltage and second voltage obtained by the at least one sensor. A length of the transmission line may be associated with a wavelength of the signal.

[Advantageous Effects of Invention]

An apparatus and method according to various embodiments of the disclosure measure voltages of a signal passing through a specific-length transmission line disposed between a power amplifier and an antenna, thereby accurately calculating power irrespective of a change in antenna impedance.

An apparatus and method according to various embodiments of the disclosure use a specific power amplifier, thereby accurately calculating power without having to dispose an additional transmission line.

In addition thereto, advantages acquired in the disclosure are not limited to the aforementioned advantages, and other advantages not mentioned herein may be clearly understood by those skilled in the art to which the disclosure pertains from the following descriptions.

[Brief Description of Drawings]

FIG. 1 illustrates an example of an electronic device according to an embodiment of the disclosure;

FIG. 2 illustrates an example of an electronic device including a Doherty power amplifier according to an embodiment of the disclosure;

FIG. 3A illustrates an example of a circuit diagram of an electronic device according to an embodiment of the disclosure;

FIG. 3B illustrates an example of a smith chart representing impedance of an antenna according to an embodiment of the disclosure;

FIG. 3C is an example of a graph illustrating a voltage peak depending on an impedance change of an antenna according to an embodiment of the disclosure;

FIG. 4 is an example of a graph illustrating a power sensing error depending on an impedance change of an antenna according to an embodiment of the disclosure;

FIG. 5 is another example of a graph illustrating a power sensing error depending on an impedance change of an antenna according to an embodiment of the disclosure;

FIG. 6 illustrates an example of a structure of an electronic device according to an embodiment of the disclosure;

FIG. 7 is a graph illustrating an output voltage depending on an output signal of an electronic device according to an embodiment of the disclosure; and

FIG. 8 illustrates a functional configuration of an electronic device according to various embodiments of the disclosure.

With regard to the description of the drawings, the same or similar reference numerals may be used to refer to the same or similar elements.

[Mode for Invention]

Terms used in the disclosure are for the purpose of describing particular embodiments only and are not intended to limit other embodiments. A singular expression may include a plural expression unless there is a contextually distinctive difference. All terms (including technical and scientific terms) used herein have the same meaning as commonly understood by those ordinarily skilled in the art disclosed in the disclosure. It will be further understood that terms, such as those defined in commonly used dictionaries, should be interpreted as having a meaning that is consistent with their meaning in the context of the relevant art, and will not be interpreted in an idealized or overly formal sense unless expressly so defined herein. Optionally, the terms defined in the disclosure should not be interpreted to exclude the embodiments of the disclosure.

A hardware-based approach is described for example in the various embodiments of the disclosure described hereinafter. However, since the various embodiments of the disclosure include a technique in which hardware and software are both used, a software-based approach is not excluded in the embodiments of the disclosure.

Hereinafter, terms used to refer to parts of an electronic device (e.g., a board structure, a substrate, a Printed Circuit Board (PCB), a Flexible PCB (FPCB), a module, an antenna, an antenna element, a circuit, a processor, a chip, a component, and a device), terms used to refer to a shape of the parts (e.g., a construction body, a construction object, a support portion, a contact portion, a protrusion, and an opening), terms used to refer to a connection portion between the construction bodies (e.g., a connection line, a feeding line, a connection portion, a contact portion, a support portion, a contact construction body, a conductive member, an assembly), terms used to refer to a circuitry (e.g., a PCB, an FPCB, a signal line, a feeding line, a data line, an RF signal line, an antenna line, an RF path, an RF module, and an RF circuit), and the like are exemplified for convenience of explanation. Therefore, the disclosure is not limited to terms described below, and thus other terms having the same technical meaning may also be used. In addition, the term '... unit', '... device', '...member', '...body', or the like may imply at least one configuration or may imply a unit of processing a function.

Conventionally, in an electronic device including a plurality of RF chains, a sensor disposed to an Integrated Circuit (IC) inside the RF chain has been used to measure power of a signal transmitted from an antenna. The power is calculated indirectly through a signal voltage measured through the sensor. However, since the voltage and power of the signal have a constant relationship only when the antenna has constant impedance, the impedance of the antenna may be changed in practice due to an external factor (e.g., an arrangement of an adjacent circuit) or the like, and thus it may be inaccurate to measure the signal power by using only the signal voltage.

Hereinafter, the disclosure proposes a structure for accurately measuring power of a signal passing through an RF chain even in an environment in which impedance of an antenna changes. A transmission line having a specific length is disposed between the antenna and a power amplifier disposed on the RF chain, and a sensor obtains voltages of signals at front and rear end of the transmission line having the specific length. Therefore, the electronic device may more accurately measure power of the signal, based on the obtained voltages.

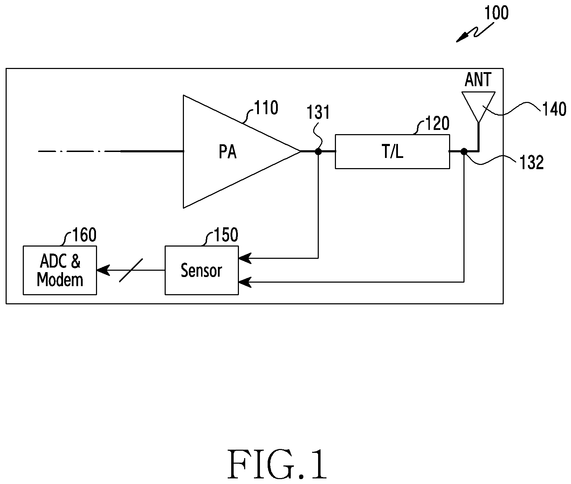

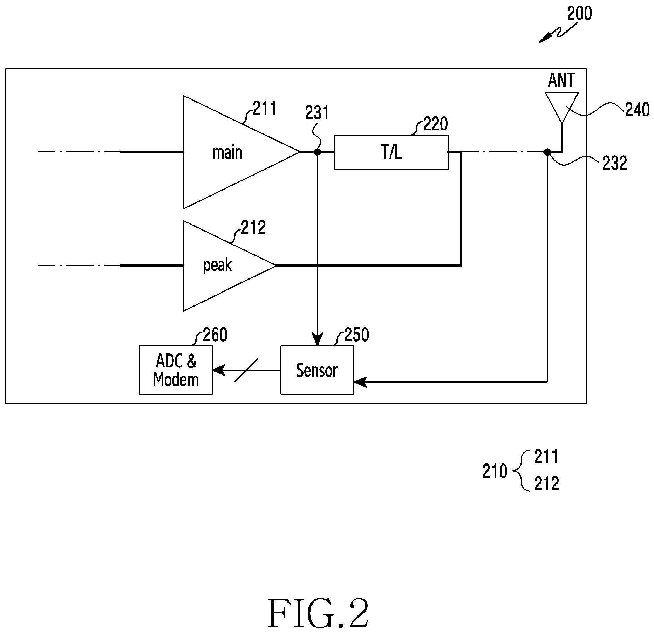

FIG. 1 illustrates an example of an electronic device according to an embodiment of the disclosure. Although an electronic device including one power amplifier, one antenna, one transmission line coupling the power amplifier and the antenna, one sensor, and one Analog to Digital Converter (ADC) & Modulation and demodulation (Modem) is illustrated in FIG. 1 for convenience of description, the disclosure is not limited thereto. For example, in the electronic device, the power amplifier and the antenna may be coupled by a plurality of transmission lines. As another example, the electronic device may include a plurality of power amplifiers, as described below with reference to FIG. 2. As another example, the plurality of sensors may be coupled to the transmission line.

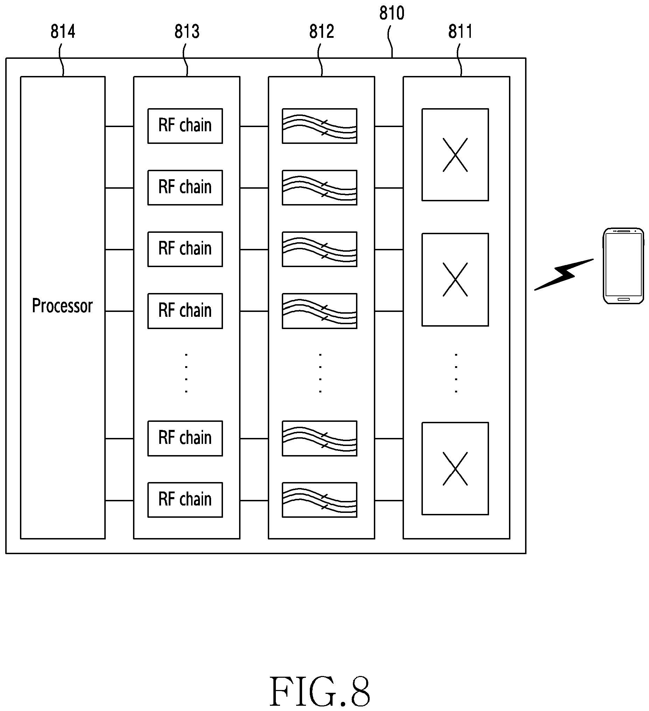

Referring to FIG. 1, an electronic device 100 may include a Power Amplifier (PA) 110, a Transmission Line (T/L) 120, an antenna 140, a sensor 150, an Analog to digital Converter & Modulation and demodulation (ADC & Modem) 160. According to an embodiment, the PA 110 may be disposed on a plurality of RF chains in the electronic device 100 including the plurality of RF chains, as described below with reference to FIG. 8. According to an embodiment, the PA 110 may be disposed on at least one RF chain among the plurality of RF chains. For example, the PA 110 may be disposed only on one RF chain among the plurality of RF chains. As another example, the PA 110 may be disposed only on some adjacent RF chains among the plurality of RF chains. As another example, the PA 110 may be disposed only any RF chains among the plurality of RF chains.

According to an embodiment, the PA 110 may be coupled to the transmission line 120. For example, the PA 110 may be coupled to one end of the transmission line 120 only at any one portion referred to as a first connection portion 131. According to another embodiment, although not shown in FIG. 1, the PA 110 may be coupled to the plurality of transmission lines 120. For example, the PA 110 may be coupled to two or more transmission lines 120.

According to an embodiment, the PA 110 may be constructed of a plurality of power amplifiers. For example, as described below with reference to FIG. 2, the PA 110 may be constructed of a Doherty power amplifier including two power amplifiers.

According to an embodiment, one end of the transmission line 120 may be coupled to an output stage of the PA 110, and the other end of the transmission line 120 may be coupled to the antenna 140. According to an embodiment, any one portion between the transmission line 120 and the output stage of the PA 110 may be referred to as the first connection portion 131, and any one portion between the transmission line 120 and the antenna 140 may be referred to as a second connection portion 132. According to an embodiment, the transmission line 120 may be a path for transmitting to the antenna 140 a signal output from the output stage of the PA 110. In addition, according to an embodiment, the transmission line 120 may be included inside the PA 110. For example, as described below with reference to FIG. 2, the transmission line 120 may be a specific-length transmission line (e.g., a quarter wave transmission line) existing inside the Doherty power amplifier.

According to an embodiment, the length of the transmission line 120 may be associated with a wavelength of a signal output from the output stage of the PA 110. For example, when the wavelength of the signal output from the PA 110 is $\lambda$, the length of the transmission line 120 may be $\lambda/4$. However, the disclosure is not limited thereto, and the length of the transmission line 120 may vary when configuring the electronic device 100. For example, the length of the transmission line 120 may be shorter than $\lambda/4$. As another example, the length of the transmission line 120 may be longer than $\lambda/4$. That is, it may mean that the length of the transmission line 120 may change by considering a design restriction of an antenna and signal or an influence of adjacent elements, when configuring the electronic device 100,

According to another embodiment, the transmission line 120 may be constructed of a lumped circuit. In other words, the transmission line may be replaced through an equivalent lumped circuit constructed to have the same impedance as that of the transmission line 120. For example, in order to construct the lumped circuit equivalent to the transmission line 120, the equivalent lumped circuit may be constructed by combining a capacitor and an inductor.

According to an embodiment, the antenna 140 may be constructed by at least one antenna element. For example, the electronic device 100 using a signal of a millimeter wave (mmWave) band may include a plurality of antenna elements to perform beamforming. In this case, one sub-array may be constructed by some antenna elements among the plurality of antenna elements. Although one antenna 140 is illustrated in FIG. 1 for convenience of description, the disclosure is not limited thereto, and it may mean that the transmission line 120 is coupled to a node to be coupled to the plurality of antenna elements.

According to an embodiment, the sensor 150 may be electrically coupled at the first connection portion 131 which is a portion between the transmission line 120 and the PA 110. In addition, the sensor 150 may be electrically coupled at the second connection portion 132 which is a portion between the transmission line 120 and the antenna 140. According to an embodiment, the sensor 150 may measure a voltage value of a signal transmitted from each of the first connection portion 131 and the second connection portion 132. For example, when a voltage at the first connection portion 131 of the signal to be transmitted is a first voltage and a voltage at the second connection portion 132 is a second voltage, the sensor may measure values of the first voltage and second voltage. In this case, the value of the first voltage and the value of the second voltage of the signal measured by the sensor 150 may mean a peak value of the voltage. According to another embodiment, a plurality of voltage values at the first connection portion 131 of the signal to be transmitted and a plurality of voltage values at the second connection portion 132 may be measured. For example, a value expressed by a representative value (e.g., an average value, a maximum value, etc.) by measuring voltages of points (e.g., 3 points) adjacent to the first connection portion 131 may mean the first voltage. As another example, a value expressed by a representative value of voltages measured by measuring a voltage for each specific period at the first connection portion 131 may mean the first voltage. In the disclosure, the measuring of the voltage may be understood as obtaining a value of the voltage.

According to an embodiment, the sensor 150 may transmit the obtained signal voltage values to the ADC & Modem 160. In detail, the sensor 150 may transmit voltage values obtained from the first connection portion 131 and the second connection portion 132 to the Modem by digitalizing signal voltage values obtained through the ADC.

According to an embodiment, the ADC & Modem 160 may calculate signal power by using the obtained signal voltage values. In other words, a value obtained by digitalizing signal voltage values obtained through the sensor 150 may be transferred to the Modem through the ADC to convert (or calculate) the obtained signal voltage values into power. According to an embodiment, the ADC & Modem 160 may calculate power by using an average value of the obtained signal voltage values. For example, when a value of the first voltage is denoted by $V_1$ and a value of the second voltage is denoted by $V_2$, the ADC & Modem 160 may calculate power through $(V_1+V_2)/2$ which is an arithmetic average of the values of the first voltage and second voltage. As another example, the ADC & Modem 160 may calculate power through a geometric average (e.g., $\sqrt{V_1 V_2}$) of the values of the first voltage and second voltage. According to another embodiment, the ADC & Modem 160 may calculate signal power, based on at least one of a maximum value, a median value, and a weight for a specific value of the first voltage and second voltage values. For example, when a first weight for the first voltage is denoted by $w_1$ and a second weight for the second voltage is denoted by $w_2$, the ADC & Modem 160 may calculate power through a voltage $V = w_1 V_1 + w_2 V_2$ (where $w_1 + w_2 = 1$) depending on weights of the first voltage and second voltage values.

As described above, the electronic device 100 may be constructed to include the transmission line 120 between the PA 110 and the antenna 140, and the sensor 150 of the electronic device 100 may measure signal voltage values at the first connection portion 131 and the second connection portion 132. In addition, the ADC & Modem 160 may convert the signal voltage values obtained by the sensor 150 into an average value or the like to calculate power of a signal transmitted by the antenna 140.

Hereinafter, a structure of an electronic device using a Doherty power amplifier instead of the power amplifier and transmission line of FIG. 1 will be described with reference to FIG. 2.

FIG. 2 illustrates an example of an electronic device including a Doherty power amplifier according to an embodiment of the disclosure. Although an electronic device including one Doherty power amplifier, one antenna, one sensor, and one ADC & Modem is illustrated in FIG. 2 for convenience of description, the disclosure is not limited thereto. For example, the electronic device may include a plurality of antennas coupled by means of a single node, and the single node may be coupled to an output stage of the Doherty power amplifier. As another example, a plurality of sensors may be coupled to a transmission line.

Referring to FIG. 2, an electronic device 200 may include a Doherty power amplifier 210, an antenna 240, a sensor 250, and an ADC & Modem 260. According to an embodiment, the Doherty power amplifier 210 may be disposed on a plurality of RF chains in the electronic device 200 including the plurality of RF chains, as described below with reference to FIG. 8. According to another embodiment, the Doherty power amplifier 210 may be disposed on at least one RF chain among the plurality of RF chains. For example, the Doherty power amplifier 210 may be disposed only on one RF chain among the plurality of RF chains. As another example, the power amplifier 210 may be disposed only on some adjacent RF chains among the plurality of RF chains. As another example, the Doherty power amplifier 210 may be disposed only any RF chains among the plurality of RF chains.

According to an embodiment, the Doherty power amplifier 210 may be coupled to one main power amplifier 211, one peak power amplifier 212, and at least one transmission line 220 coupling the main power amplifier 211 and the peak power amplifier 212. The transmission line 220 coupling the main power amplifier 211 and the peak power amplifier 212 is assumed as one transmission 220 in FIG. 2 only for convenience of description, and the disclosure is not limited thereto. For example, a transmission line for signal distribution may also be disposed at respective input stages of the main power amplifier 211 and the peak power amplifier 212. In other words, the transmission line 220 of FIG. 2 means a transmission line existing inside the Doherty power amplifier 210, and it may not mean that an additional transmission line is disposed to the electronic device 200. Therefore, the transmission line 120 of FIG. 1 and the transmission line 220 of FIG. 2 may not mean the same transmission signal.

According to an embodiment, one end of the transmission line 220 may be coupled to an output stage of the main power amplifier 211, and another end of the transmission line 220 may be coupled to the peak power amplifier 212 and the antenna 240. For example, any one portion between the transmission line 220 and the main power amplifier 211 may be referred to as a first connection portion 231. As another example, any one portion between the transmission line 220 and the peak power amplifier 212 or between the transmission line 220 and the antenna 240 may be referred to as a second connection portion 232. Although any one portion between the transmission line 220 and the antenna 240 is illustrated in FIG. 2 as the second connection portion 232, even if any one portion between the transmission line 220 and the peak power amplifier 212 serves as the second connection portion 232, it is electrically the same node in practice and thus may be understood to be the same. According to an embodiment, the transmission line 220 may be disposed inside the Doherty power amplifier 210, which may be a path for transmitting signals output from an output stage of each power amplifier inside the Doherty power amplifier 210 to the antenna 240.

According to an embodiment, a length of the transmission line 220 may be associated with a wavelength of signals output from the output stages of the main power amplifier 211 and peak power amplifier 212 of the Doherty power amplifier 210. For example, when the wavelength of the signal output from the Doherty power amplifier 210 is denoted by $\lambda$, the length of the transmission line 220 may be $\lambda/4$.

According to an embodiment, the antenna 240 may be constructed by at least one antenna element. For example, the electronic device 200 using a signal of a mmWave band may include a plurality of antenna elements to perform beamforming. In this case, one sub-array may be constructed by some antenna elements among the plurality of antenna elements. Although one antenna 240 is illustrated in FIG. 1 for convenience of description, the disclosure is not limited thereto, and it may mean that the transmission line 220 is coupled to a node to be coupled to the plurality of antenna elements.

According to an embodiment, the sensor 250 may be electrically coupled at the first connection portion 231 which is a portion between the transmission line 220 and the main amplifier 211 of the Doherty power amplifier 210. In addition, the sensor 250 may be electrically coupled at the second connection portion 232 which is a portion between the transmission line 220 and the antenna 240 or between the transmission line 220 and the peak power amplifier 212. According to an embodiment, the sensor 250 may measure a voltage value of a signal transmitted from each of the first connection portion 231 and the second connection portion 232. For example, when a voltage at the first connection portion 231 of the signal to be transmitted is a first voltage and a voltage at the second connection portion 232 is a second voltage, the sensor may measure values of the first voltage and second voltage. In this case, the value of the first voltage and the value of the second voltage of the signal measured by the sensor 250 may mean a peak value of the voltage. According to another embodiment, a plurality of voltage values at the first connection portion 231 of the signal to be transmitted and a plurality of voltage values at the second connection portion 232 may be measured. For example, a value expressed by a representative value (e.g., an average value, a maximum value, etc.) by measuring voltages of points (e.g., 3 points) adjacent to the first connection portion 231 may mean the first voltage. As another example, a value expressed by a representative value of voltages measured by measuring a voltage for each specific period at the first connection portion 231 may mean the first voltage. In the disclosure, the measuring of the voltage may be understood as obtaining a value of the voltage.

According to an embodiment, the sensor 250 may transmit the obtained signal voltage values to the ADC & Modem 260. In detail, the sensor 250 may transmit voltage values obtained from the first connection portion 231 and the second connection portion 232 to the Modem by digitalizing signal voltage values obtained through the ADC.

According to an embodiment, the ADC & Modem 260 may calculate signal power by using the obtained signal voltage values. In other words, a value obtained by digitalizing signal voltage values obtained through the sensor 250 may be transferred to the Modem through the ADC to convert (or calculate) the obtained signal voltage values into power. According to an embodiment, the ADC & Modem 260 may calculate power by using an average value of the obtained signal voltage values. For example, when a value of the first voltage is denoted by $V_1$ and a value of the second voltage is denoted by $V_2$, the ADC & Modem 260 may calculate power through $(V_1+V_2)/2$ which is an arithmetic average of the values of the first voltage and second voltage. As another example, the ADC & Modem 260 may calculate power through a geometric average (e.g., $\sqrt{V_1 V_2}$) of the values of the first voltage and second voltage. According to another embodiment, the ADC & Modem 260 may calculate signal power, based on at least one of a maximum value, a median value, and a weight for a specific value of the first voltage and second voltage values. For example, when a first weight for the first voltage is denoted by $w_1$ and a second weight for the second voltage is denoted by $w_2$, the ADC & Modem 260 may calculate power through a voltage $V=w_1V_1+w_2V_2$ (where $w_1+w_2=1$) depending on weights of the first voltage and second voltage values.

As described above, the electronic device 200 may be constructed to include the Doherty power amplifier 210 and the antenna 240, and the sensor 250 of the electronic device 200 may measure signal voltage values at the first connection portion 231 and the second connection portion 232. In addition, the ADC & Modem 260 may convert the signal voltage values obtained by the sensor 250 into an average value or the like to calculate power of a signal transmitted by the antenna 240.

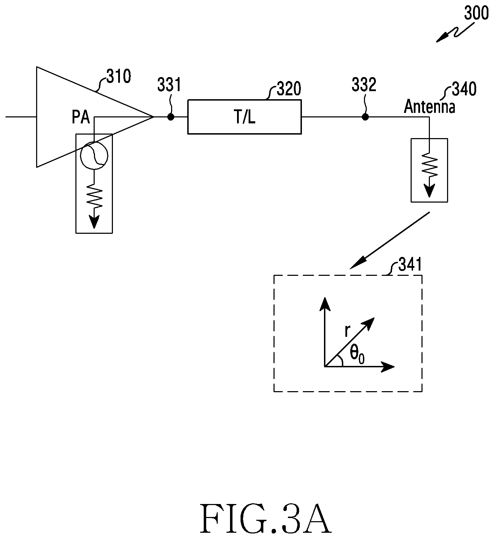

A voltage of a signal has conventionally been measured at one point between a power amplifier and an antenna to calculate power of the signal, which may result in a change in impedance of the antenna. Accordingly, since a relationship between the voltage and the power may not be constant, an error may occur when measuring the power of the signal. Therefore, a structure of being electrically coupled to the sensor to measure a voltage at front and rear ends of a transmission line having a specific length according to an embodiment of the disclosure (hereinafter, a sensing structure based on a quarter wave transmission line) may be used to calculate power through a representative value (e.g., an average value, a median value, a weight, a maximum value, etc.) of voltages obtained at the front and rear ends of the transmission line, thereby minimizing an error of power calculation. A process for this will be described in detail with reference to FIG. 3A to FIG. 7.

Although an example in which power is calculated based on an average value depending on an arithmetic average of voltages measured by a sensor is described hereinafter, the power may also be calculated based on a voltage value calculated by using a geometric average, a weight, or the like as described above.

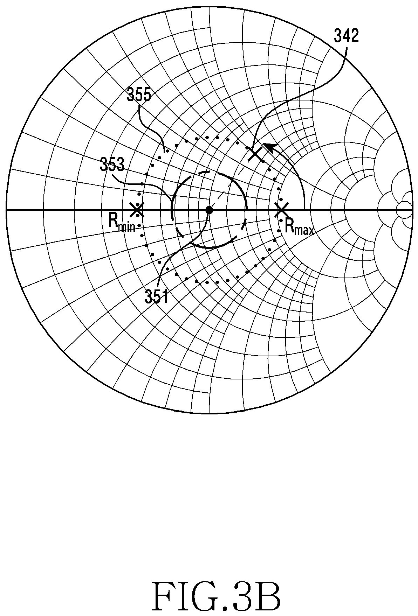

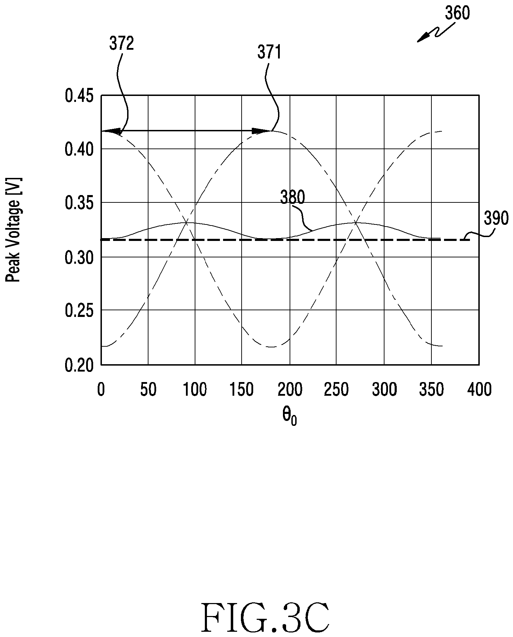

FIG. 3A illustrates an example of a circuit diagram of an electronic device according to an embodiment of the disclosure. FIG. 3B illustrates an example of a smith chart representing impedance of an antenna according to an embodiment of the disclosure. A circuit diagram of an electronic device 300 which is a simplification of the electronic device 100 of FIG. 1 is illustrated for convenience of description in FIG. 3A. Therefore, the electronic device 300 of FIG. 3A may be understood as the same as the electronic device 100 of FIG. 1. For example, the description on the PA 110 of FIG. 1 may be applied to a PA 310 of FIG. 3. However, FIG. 3A is only a simplified circuit diagram of the electronic device 100 of FIG. 1 for convenience of description, and the electronic device 300 of FIG. 3A may be understood as the same as the electronic device 200 using the Doherty power amplifier 210 of FIG. 2.

Referring to FIG. 3A, the electronic device 300 may include the PA 310, a transmission line 320, and an antenna 340. The PA 310 may be replaced with equivalent impedance and power. In addition, the antenna 340 may be replaced with equivalent impedance. According to an embodiment, a first connection portion 331 may be any portion between the transmission line 320 and the PA 310, and a second connection portion 332 may be any portion between the transmission line 320 and the antenna 340. According to an embodiment, a sensor (not shown) may measure values of a first voltage and second voltage of respective signals at the first connection portion 331 and the second connection portion 332. The sensor may transmit the values of the first voltage and second voltage of the obtained signal to an ADC & Modem (not shown) of the electronic device 300, and thus the ADC & Modem may calculate signal power. For example, the signal power may be calculated as an average value of the first and second volage values.

According to an embodiment, a length of the transmission line 320 may be associated with a wavelength of a signal passing through the transmission line 320. For example, when the signal wavelength is $\lambda$, the length of the transmission line 320 may be λ/4. For convenience of description, it is assumed hereinafter that the length of the transmission line 320 is signal wavelength/4 (λ/4).

According to an embodiment, impedance of the antenna 340 may be expressed in the form of a phasor. As shown in a figure 341 of FIG. 3A, impedance of the antenna 340 may be defined by a function of r which denotes a magnitude of impedance and $\theta_0$ which denotes a phase of impedance. r may be expressed by a product of a Voltage Standing Wave Ratio (VSWR) and a reference resistor $R_0$. That is, it may be r=VSWR*$R_0$.

Hereinafter, for convenience of description, it is assumed that a return loss of the impedance of the antenna 340 is about 10dB, and a reference resistance $R_0$ is 50Ω. In other words, when the return loss of the impedance of the antenna 340 is about 10dB, it may mean that a VSWR has a value of about 1.925 due to a relationship of the VSWR and the return loss. In addition, power transfer efficiency may be the best in general when the impedance of the transmission line 320 is about 32Ω, and a signal waveform may be distorted as little as possible when the impedance of the transmission line 320 is about 75Ω. Therefore, when the impedance of the transmission line 320 is about 50Ω which is a median value, the transmission line 320 may be designed such that a signal waveform has high power transfer efficiency and low distortion. Accordingly, when matching impedance of the antenna 340 is also about 50Ω, the antenna 340 may have high efficiency when radiating a signal. Therefore, it is assumed that the reference resistance $R_0$ of the impedance of the antenna 340 is about 50Ω.

Referring to FIG. 3B, a first point 342 on a smith chart may mean antenna impedance expressed by r and $\theta_0$. A second point 351 may mean a point at which a VSWR is 1 and a characteristic impedance is normalized to a reference resistance $R_0$ (50Ω). A first circle 353 may mean a set of points at which a VSWR is 1.5. A second circle 355 may mean a set of points at which a VSWR is 2. According to an embodiment, the first point 342 may change to a point in the range of $R_{max}$ and $R_{min}$, with a change in the impedance of the antenna 340. $R_{max}$ may mean VSWR*$R_0$, and $R_{min}$ may mean VSWR/$R_0$. For example, $R_0$ may mean a reference resistance, and may be 50Ω. That is, $R_{max}$ may have a magnitude of about 100Ω, and $R_{min}$ may have a magnitude of about 25Ω. As illustrated in FIG. 3B, the impedance of the antenna 340 may change, and the first voltage of the first connection portion 331 and the second voltage of the second connection portion 332 of FIG. 3A may change depending on the change in the impedance of the antenna 340. Hereinafter, the change in the first voltage and second voltage depending on the change in the impedance will be described with reference to FIG. 3C.

FIG. 3C is an example of a graph illustrating a voltage peak depending on an impedance change of an antenna according to an embodiment of the disclosure. A horizontal axis of a graph 360 of FIG. 3C means a phase (unit: degree °) of the impedance of the antenna, and a vertical axis of the graph 360 means a voltage peak value (unit: volt, V) of a signal obtained at a first connection portion and a second connection portion when a signal of 0dBm is output from the power amplifier of FIG. 3A. In addition, for convenience of description, a self-loss of the transmission line 320 of FIG. 3A is excluded in the illustration.

Referring to FIG. 3C, the graph 360 shows a first line 371 indicating a voltage peak value of a first voltage obtained by the first connection portion 331 of FIG. 3A, a second line 372 indicating a voltage peak value of a second voltage obtained by the second connection portion 332 of FIG. 3B, a third line 380 indicating an average value of the voltage peak values of the first voltage and second voltage, and a fourth line 390 indicating a voltage peak value of a reference voltage $V_0$ at a reference resistance (about 50Ω).

Referring to the first line 371, the voltage peak value of the first voltage may change depending on a change in a phase of antenna impedance. For example, when the phase of antenna impedance is 0°, the voltage peak value of the first voltage may be about 0.22V. In addition, when the phase of antenna impedance is 180°, the voltage peak value of the first voltage may be about 0.42V. Referring to the second line 372, the voltage peak value of the second voltage may change depending on a change in a phase of antenna impedance. For example, when the phase of antenna impedance is 0°, the voltage peak value of the second voltage may be about 0.42V. In addition, when the phase of antenna impedance is 180°, the voltage peak value of the second voltage may be about 0.22V.

Referring to the first line 371 and the second line 372, the first line 371 may be constructed to have a phase difference of 180° with respect to the second line 372. The first line 371 and the second line 372 may have the phase difference of 180° due to synthesis of a signal passing through the specific-length transmission line 320 of FIG. 3A (e.g., a quarter wave transmission line) and a reflected wave of the signal. In order to have the phase difference of 180° as described above, the phase difference between the first volage and the second voltage may be 180° when the transmission line 320 has a length corresponding to wavelength/4 of the signal passing through the transmission line 320. In terms of antenna impedance, when the phase difference between a point having a maximum voltage peak value and a point having a minimum voltage peak value is 180° in the first line 371 and the second line 372, it may mean a case where respective antenna impedance values are $R_{max}$ and $R_{min}$ in the smith chart of FIG. 3B. For example, when the reference resistance $R_0$ is 50Ω, $R_{min}$ may mean 25Ω and $R_{max}$ may mean 100Ω.

The third line 380 which means an average value of the voltage peak values of the first voltage and second voltage may be expressed by an equation of a reference voltage and a reflection coefficient as shown in <Equation 1> below.

【Equation 1】

$$V_{avg} = \frac{\sqrt{(1 + |\Gamma|^2 + 2|\Gamma|\cos\Theta_0)} + \sqrt{(1 + |\Gamma|^2 - 2|\Gamma|\cos\Theta_0)}}{2} V_0$$

$V_{avg}$ denotes an arithmetic average value of the first voltage and second voltage. $\Gamma$ denotes a reflection coefficient of antenna impedance. $V_0$ denotes a reference voltage of a signal transmitted from an antenna when the antenna impedance is the reference resistance $R_0$ (e.g., 50Ω). $\theta_0$ denotes a phase of the antenna impedance.

Referring to the third line 380, the average value of the voltage peak values of the first voltage and second voltage may change depending on a change in a phase of antenna impedance. For example, when the phase of antenna impedance is 0°, the average value of the voltage peak values of the first voltage and second voltage may be about 0.3V. When the phase of antenna impedance is about 90°, the average value of the voltage peak values of the first voltage and second voltage may be about 0.32V. When the phase of antenna impedance is about 180°, the average value of the voltage peak values of the first voltage and second voltage may be about 0.3V. According to an embodiment, regarding the change in the voltage peak value depending on the change in the phase of antenna impedance, the third line 380 may be less changed compared to the first line 371 and the second line 372 with respect to the fourth line 390 which means a reference voltage. In other words, it may mean that the voltage peak value of the average value of the first voltage and second voltage has a lower error than the respective voltage peak values of the first voltage and second voltage.

According to an embodiment, when the third line 380 is compared with the first line 371 and the second line 372, antenna impedance remains at a value of the reference resistance $R_0$ and thus an error with respect to the third line 390 which remains at a value of the reference voltage $V_0$ may be the lowest. For example, when the phase of antenna impedance is 0°, the third line 380 may coincide with the fourth line 390, and when the phase of antenna impedance is 180°, the third line 380 may coincide with the fourth line 390. That is, when the transmission line 320 has a length corresponding to wavelength/4 of the signal passing through the transmission line 320 as shown in FIG. 3A, if power is calculated by using an average value of voltage values of a signal measured and obtained at a front end (e.g., a first connection portion) and rear end (e.g., a second connection portion) of the transmission line 320, a power measurement error may be lower than the other cases.

As described above, an error may occur when signal power is measured through a signal voltage obtained at one portion between the power amplifier and the antenna. For example, assuming that a reflection coefficient of the antenna impedance is about 10dB, a VSWR may be about 1.925, and a voltage applied to an antenna stage may change up to about twice according to a definition of the VSWR. When this is converted into a decibel value, it may mean that the measured voltage may have an error of about 6dB. In general, since a plurality of RF chains may be used in case of an electronic device using a signal of an mmWave band, a higher error may occur in the electronic device due to an error occurring in each RF chain. Therefore, in a sensing structure based on a quarter waver transmission line according to an embodiment of the disclosure, power may be calculated with a lower error than the conventional case, by calculating power based on an average value of voltage values of a front end (e.g., a first connection portion) and rear end (e.g., a second connection portion) of the transmission line (e.g., the quarter wave transmission line).

Hereinafter, an error between power calculated by an apparatus and method according to an embodiment of the disclosure and power for case where a reference voltage is applied to an antenna is described. In addition, calculating of power by using an average value (e.g., an arithmetic average) for a plurality of voltages measured by an apparatus and method according to an embodiment of the disclosure will be described in comparison with calculating of power by performing a multiplication operation on a plurality of voltages measured by an apparatus and method according to another embodiment of the disclosure.

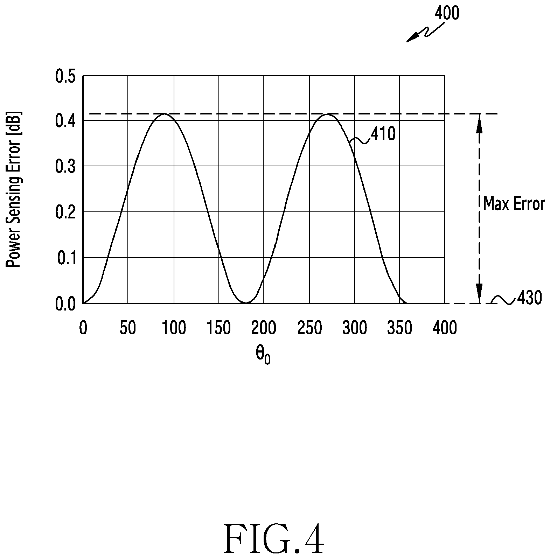

FIG. 4 is an example of a graph illustrating a power sensing error depending on an impedance change of an antenna according to an embodiment of the disclosure. A graph 400 illustrates an error of power based on a voltage peak value of the third line 380 of FIG. 3C in comparison with an error of power based on a voltage peak value of the third line 390. A horizontal axis of the graph 400 means a phase (e.g., unit: degree, °) of antenna impedance, and a vertical axis of the graph 400 means a power sensing error (e.g., unit: decibel, dB). For convenience of description, it is assumed in the graph 400 that a VSWR is 1.925.

Referring to FIG. 4, the graph 400 shows a fifth line 410 indicating an error of power based on a voltage peak value of the third line 380 in the graph of FIG. 3C and a sixth line 430 indicating an error of power based on a voltage peak value of the fourth line 390 in the graph of FIG. 3C.

Referring to the fifth line 410, the power sensing error may change depending on a change in a signal phase. For example, when the phase of antenna impedance is 0°, a power sensing error value may be about 0dB. When the phase of antenna impedance is 180°, the power sensing error value may be about 0dB. In addition, when the phase of antenna impedance is 90°, the power sensing error value may be about 0.412dB. Unlike this, referring to the sixth line 430, the power sensing error may remain at 0dB depending on a change in a signal phase. Since it is power of a signal having a reference voltage value applied to an antenna, a power sensing error (e.g., an error) may not exist in the sixth line 430.

Comparing the fifth line 410 and the sixth line 430, a max error of the power sensing error value may be about 0.412dB. A max error value of the fifth line 410 against the sixth line 430 may be defined by a VSWR or a reflection coefficient. This may be expressed by <equation 2> below.

【Equation 2】

$$Max\ Error = 10\log(1 + |\Gamma|^2) = 10\log(1 + \left|\frac{VSWR-1}{VSWR+1}\right|^2)$$

Max Error denotes a max error of a power sensing error value. $\Gamma$ denotes a reflection coefficient. VSWR denotes a voltage standing wave ratio of antenna impedance.

Referring to the aforementioned equation and graph 400, the max error value of the power sensing error value may change by the VSWR or the reflection coefficient. For example, the max error of the power sensing error value may decrease as the VSWR approaches 1. As another example, the max error of the power sensing error value may decrease as the reflection coefficient approaches 0.

Referring to FIG. 3 and FIG. 4, the power sensing error value may be calculated based on the voltage peak value of the signal, and the max power of the power sensing error value may be great when a difference between the voltage peak value and the reference voltage is great. In other words, it may mean that the greater the difference between voltage peak value and the reference voltage, the higher the error occurring in the process of sensing power. Therefore, power measurement using an apparatus and method according to an embodiment of the disclosure may have a lower error than power measurement using the conventional technique.

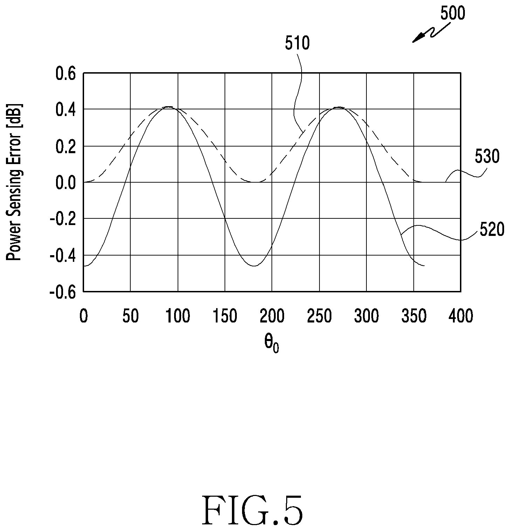

It has been described above that power is calculated through an average value (e.g., an arithmetic average) of voltage peak values of a front end (e.g., a first connection portion) and rear end (e.g., a second connection portion) of a transmission line with reference to FIG. 4, and the calculated power may be used to compare an error with respect to power, based on a reference voltage. Hereinafter, a power sensing error based on the average value of the voltage peak values of the front end and rear end of the transmission line will be described with reference to FIG. 5 in comparison with a power sensing error calculated by performing a multiplication operation on voltage peak values of the front end and rear end of the transmission line.

FIG. 5 is another example of a graph illustrating a power sensing error depending on an impedance change of an antenna according to an embodiment of the disclosure. A horizontal axis of a graph 500 means a phase (e.g., unit: degree, °) of antenna impedance, and a vertical axis of the graph 500 means a power sensing error (e.g., unit: decibel, dB). For convenience of description, it is assumed in the graph 500 that a VSWR is 1.925.

Referring to FIG. 5, the graph 500 shows a seventh line 510 indicating an error of power based on the voltage peak value of the third line 380 in the graph of FIG. 3C, an eighth line 520 indicating an error of power calculated by multiplying the voltage peak values of the first line 371 and second line 372 in the graph of FIG. 3C, and a ninth line 530 indicating the error of power based on the voltage peak value of the fourth line 390 in the graph of FIG. 3C. The seventh line 510 of the graph 500 may be understood as the same as the fifth line 410 of the graph 400 of FIG. 3. In addition, the ninth line 530 of the graph 500 may be understood as the same as the sixth line 430 of the graph 400 of FIG. 4. In other words, the description on the fifth line 410 and sixth line 430 of FIG. 4 may be equally applied to the seventh line 510 and ninth line 530 of FIG. 5.

Referring to the eighth line 520, a power sensing error may change depending on a change in a phase of antenna impedance. For example, when the phase of antenna impedance is 0°, a power sensing error value may be about -0.44dB. When the phase of antenna impedance is 180°, the power sensing error value may be about -0.44dB. In addition, when the phase of antenna impedance is about 90°, the power sensing error value may be about 0.412dB.

Comparing the eighth line 520 and the ninth line 530, a max error of the power sensing error value may be about -0.44dB. A max error value of the eighth line 520 against the ninth line 530 may be defined by a VSWR or a reflection coefficient. This may be expressed by <equation 3> below.

【Equation 3】

$$Max\ Error = 10\log(1 + \frac{1+|\Gamma|^2}{1-|\Gamma|^2})$$

Max Error denotes a max error of a power sensing error value. $\Gamma$ denotes a reflection coefficient.

Referring to the aforementioned equation and graph 500, the max error value of the power sensing error value may change by the reflection coefficient. For example, the max error of the power sensing error value may decrease as the reflection coefficient approaches 0.

Comparing the seventh line 510 and the eighth line 520, when the phase of antenna impedance is about 90°, the power sensing error value is similar as about 0.412dB, whereas when the phase of antenna impedance is about 0° or 180°, the power sensing error value may be different by about 0.44dB. In addition, the seventh line 510 may have a small difference in a power sensing error with respect to the ninth line 530, whereas the eighth line 520 may have a greater different in the power sensing error than the seventh line 510 with respect to the ninth line 530.

In other words, a power sensing error value for a case where power is calculated by using an average value (e.g., an arithmetic average) obtained at a front end (e.g., a first connection portion) and rear end (e.g., a second connection portion) of a transmission line may have a lower error than a power sensing error value for a case where power is calculated by performing a multiplication operation on the obtained voltages, and power may be measured more accurately when power is calculated by using the average value.

Hereinafter, the conventional structure and a structure according to an embodiment of the disclosure are compared for description, and a relationship between power and voltage output from an antenna according to each structure is described.

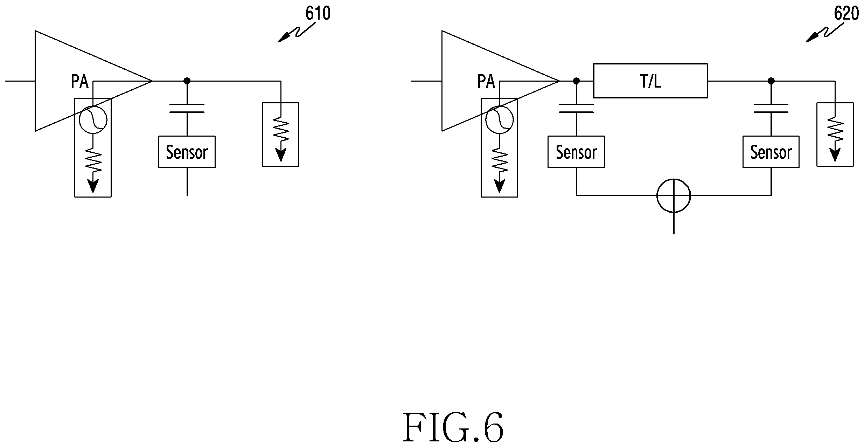

FIG. 6 illustrates an example of a structure of an electronic device according to an embodiment of the disclosure. An electronic device 610 of FIG. 6 has a structure of the conventional electronic device, and an electronic device 620 has a structure of an electronic device according to an embodiment of the disclosure.

Referring to FIG. 6, the electronic device 610 may include one Power Amplifier (PA) expressed as equivalent resistance and equivalent power, an antenna expressed as equivalent resistance, and a sensor subjected to coupling by a capacitor at one point between the PA and the antenna. Unlike this, the electronic device 620 according to an embodiment of the disclosure may include one PA expressed as equivalent resistance and equivalent power, an antenna expressed as equivalent resistance, a specific-length transmission line connecting between the PA and the antenna, and two sensors. According to an embodiment, the two sensors of the electronic device 620 may sense a signal voltage respectively at one point between the PA and the transmission line and one point between the transmission line and the antenna. According to an embodiment, the two sensors of the electronic device 620 may calculate power by transferring voltage values obtained through sensing to an ADC & Modem (not shown). For example, the ADC & Modem may calculate power by using an average value (e.g., an arithmetic average, a geometric average) of obtained voltages. As another example, the ADC & Modem may calculate power by using a representative value (e.g., a weight for a maximum value, median value, and reference value) of the obtained voltages. FIG. 6 illustrates an electronic device only for convenience of description, and an apparatus and method according to an embodiment of the disclosure are not limited thereto. For example, as described above in FIG. 2, the electronic device 620 may include a Doherty power amplifier constructed of a plurality of power amplifiers and a transmission line (e.g., a quarter wave transmission line). As another example, the electronic device 620 may include one or more sensors, and the one or more sensors may sense a signal voltage at a front end and rear end of the transmission line.

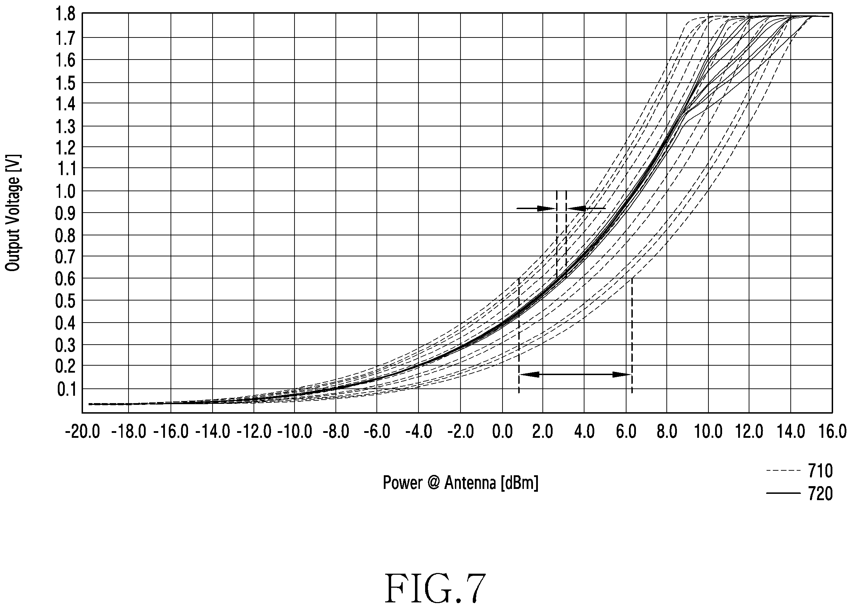

FIG. 7 is a graph illustrating a signal output voltage depending on an output signal of an electronic device according to an embodiment of the disclosure. A horizontal axis of the graph means power (unit: dBm) output from an antenna, and a vertical axis of the graph means an output voltage (unit: V) of a signal obtained by a sensor. For convenience of description, it is assumed in FIG. 7 that a return loss is 10dB.

Referring to FIG. 7, first lines 710 indicating an output voltage of a signal obtained according to power output from the antenna of the electronic device 610 of FIG. 6 and second lines 720 indicating an output voltage of a signal obtained according to power output from the antenna of the electronic device 620 of FIG. 6 are illustrated. According to an embodiment, the first lines 710 may mean an output voltage obtained from a sensor according to output power, when a phase of antenna impedance changes by a specific value. For example, among the first lines 710, a line closest to a y-axis may mean an output voltage when the antenna impedance is $R_{max}$. As another example, among the first lines 710, a line farthest from the y-axis may mean an output voltage when the impedance of the antenna is $R_{min}$. According to an embodiment, the second lines 720 may mean an output voltage which is an average value (e.g., an arithmetic average) of voltages obtained from a sensor according to output power, when the phase of antenna impedance changes by a specific value. For example, among the second lines 720, a line closets to the y-axis may mean an output voltage when the antenna impedance is $R_{max}$. As another example, among the second lines 720, a line farthest from the y-axis may mean an output voltage when the antenna impedance is $R_{min}$.

Referring to the first lines 710, when the output voltage is 0.6V, the output power of the antenna may be from about 1dBm to about 6dBm. That is, as the antenna impedance changes, power output from the antenna may be output differently with a great width even in case of the same output voltage. Unlike this, referring to the second lines 720, the output power of the antenna may be about 3dBm when the output voltage is 0.6V. That is, even if the antenna impedance changes, power output from the antenna may be almost the same in case of the same output voltage.

In summary, similarly to the first lines 710, when power is calculated through one output voltage obtained by a sensor, the output power may change depending on a change in antenna impedance even in case of the same output voltage. Unlike this, similarly to the second lines 720, when power is calculated through an output voltage which is an

EP 4 231 024 B1

average value of output voltages obtained by the sensor, the output voltage and the output power may have a constant relationship. Accordingly, in the case of the conventional structure, power consumed by an RF chain may have a high error with respect to power obtained by a sensor and calculated based on the voltage. However, in case of a structure according to an embodiment of the disclosure, the power consumed by the RF chain may have a low error with respect to power obtained by a sensor and calculated based on the voltage. For example, when a VSWR of antenna impedance of an electronic device is about 1.925 (i.e., when a return loss of the antenna impedance is about 10 dB), an error of power calculated using the conventional structure may be about 5.5dB. However, an error of power calculated using an apparatus and method according to an embodiment of the disclosure may be about 0.412 dB.

Referring to FIG. 1 to FIG. 7, an apparatus and method for calculating power based on a voltage of a front end and rear end of a transmission line in a sensing structure based on a quarter wave transmission line according to an embodiment of the disclosure provide a more accurate measurement result than calculating of power based on a voltage at one point between the exiting power amplifier and an antenna. Since it is possible to minimize an error between power to be calculated and power to be output even if the antenna impedance changes, a method of calculating power based on the voltage of the front end and rear end of the transmission line may provide a more practical result compared to the existing method of calculating power based on the voltage only at one end.

In general, in a method of directly measuring power to be output, a size of an electronic device may be increased due to a measurement device disposed to the electronic device, and a loss may occur due to the measurement device itself. Therefore, power shall be measured indirectly through a voltage. However, since a voltage obtained by a sensor may change due to antenna impedance even in case of the same output, calculating of power by using one voltage may result in a high error with respect to power to be output in practice. Unlike this, since an apparatus and method according to an embodiment of the disclosure calculate power based on voltages of a front end and rear end of a transmission line by using a transmission line (e.g., a quarter wave transmission line) disposed between a power amplifier and an antenna or a transmission line existing inside a power amplifier (e.g., a Doherty power amplifier), an error with respect to power to be output in practice may be low despite a change in antenna impedance.

According to an embodiment, since a transmission line existing inside a power amplifier (e.g., a Doherty power amplifier) is used for the aforementioned power measurement, power consumption may be minimized. When power of the electronic device is measured directly, accuracy may be higher than a case where power is measured indirectly. However, it is inefficient since a size of the electronic device may be increased due to a device for performing direct measurement, and power may be consumed by the device. Unlike this, an apparatus and method for calculating power through the sensing structure based on the quarter wave transmission line according to an embodiment of the disclosure may secure accuracy similar to a method of directly measuring power, since power is calculated and a plurality of voltages are measured by using a transmission line inside a Doherty power amplifier. In addition, since a separate measurement device is not additionally required, it may also be efficient in terms of power consumption.

Since power is measured through the aforementioned structure, an apparatus and method according to an embodiment of the disclosure may provide a more efficient result than a case of using a signal of a mmWave band. For example, assuming that a return loss of an antenna is 10dB as described above, an error of power calculated in one RF chain according to the conventional structure may be about 6dB. In this case, if the signal of the mmWave band is used, a plurality of RF chains may be included in the electronic device. Accordingly, when the electronic device uses the signa of the mmWave band, an error between power to be calculated and power consumed in practice may be high. In order to minimize an influence used by the high error, the sensing structure based on the quarter wave transmission line according to an embodiment of the disclosure may be used.

An electronic device which transmits a signal of a mmWave band may require accurate power measurement for efficient power distribution. In addition, the signal of the mmWave band may change sensitively due to various factors. In the electronic device which transmits the signal of the mmWave band, power calculation through a sensing structure based on a quarter wave transmission line may be predicted (calculated) similarly to power consumed in practice in the electronic device.

In other words, since a specific-length transmission line (e.g., a quarter wave transmission line) included in the plurality of RF chains is used, an error between power to be calculated and power consumed in practice may be low (e.g., about 0.412dB). Accordingly, power distribution may be achieved efficiently.

According to an embodiment of the disclosure, a method of measuring power of a signal may include obtaining, by at least one sensor, a first voltage of the signal at a first point between a power amplifier and a transmission line, obtaining, by the at least one sensor, a second voltage of the signal at a second point between the transmission line and an antenna, and calculating power, based on the first voltage and the second voltage. A length of the transmission line may be associated with a wavelength of the signal.

In an embodiment, the length of the transmission line may be a quarter of the wavelength of the signal.

In an embodiment, the power amplifier may be a Doherty power amplifier. The transmission line may be a transmission line having a length which is a quarter of the wavelength of the signal existing inside the Doherty power amplifier.

In an embodiment, when a phase of the first voltage is a first phase and a phase of the second voltage is a second phase, a phase difference between the first phase and the second phase may be about 180°.

In an embodiment, the calculating of the power may be based on an average value of the first voltage and the second voltage.

In an embodiment, the average value may be an arithmetic average value of the first voltage and the second voltage.

In an embodiment, the calculating of the power may be based on at least one of a maximum value, median value, or weight of the first voltage and the second voltage.

An electronic device of a wireless communication system according to an embodiment of the disclosure described above may include a power amplifier, an antenna, a transmission line, at least one sensor, and at least one processor electrically coupled to the at least one sensor. The at least one sensor may be configured to obtain a first voltage of a signal at a first point between the power amplifier and the transmission line, and obtain a second voltage of the signal at a second point between the transmission line and the antenna. The at least one processor may be configured to calculate power, based on the first voltage and second voltage obtained by the at least one sensor. A length of the transmission line may be associated with a wavelength of the signal.

In an embodiment, the length of the transmission line may be a quarter of the wavelength of the signal.

In an embodiment, the power amplifier may be a Doherty power amplifier. The transmission line may be a transmission line having a length which is a quarter of the wavelength of the signal existing inside the Doherty power amplifier.

In an embodiment, when a voltage of the first point is a first voltage and a phase of the first voltage is a first phase, a second phase of a second voltage which is a voltage of the second point may have a phase difference of about 180° with respect to the first phase.

In an embodiment, the at least one processor may be configured to calculate the power, based on an average value of the first voltage and the second voltage.

In an embodiment, at least part of the support member is constructed of a metal material, and the average value may be an arithmetic average value of the first voltage and the second voltage.

In an embodiment, the at least one processor may be configured to calculate the power, based on at least one of a maximum value, median value, or weight of the first voltage and the second voltage.

An electronic device of a wireless communication system according to an embodiment of the disclosure described above may include a plurality of RF chains, a plurality of antennas corresponding to the plurality of RF chains, a transmission line, at least one sensor, and at least one processor electrically coupled to the at least one sensor. Among the plurality of RF chains, at least one RF chain may include a power amplifier. The at least one sensor may be configured to obtain a first voltage of a signal at a first point between the power amplifier and the transmission line, and obtain a second voltage of the signal at a second point between the at least one antenna among the plurality of antennas and the transmission line. The at least one processor may be configured to calculate power, based on the first voltage and second voltage obtained by the at least one sensor. A length of the transmission line may be associated with a wavelength of the signal.

In an embodiment, the length of the transmission line may be a quarter of the wavelength of the signal.

In an embodiment, the power amplifier may be a Doherty power amplifier. The transmission line may be a transmission line having a length which is a quarter of the wavelength of the signal existing inside the Doherty power amplifier.

In an embodiment, when a voltage of the first point is a first voltage and a phase of the first voltage is a first phase, a second phase of a second voltage which is a voltage of the second point may have a phase difference of about 180° with respect to the first phase.

In an embodiment, the at least one processor may be configured to calculate the power, based on an average value of the first voltage and the second voltage.

In an embodiment, the at least one processor may be configured to calculate the power, based on at least one of a maximum value, median value, or weight of the first voltage and the second voltage.

FIG. 8 illustrates a functional configuration of an electronic device according to various embodiments of the disclosure. An electronic device 810 may mean the electronic device 100 of FIG. 1 or the electronic device 200 of FIG. 2. According to an embodiment, the electronic device 810 may be an electronic device using a signal of a mmWave band. In a structure mentioned with reference to FIG. 1 to FIG. 7 in which a specific-length transmission line (e.g., a quarter wave transmission line) is disposed between a power amplifier and antenna or in which a specific length-transmission line (e.g., a quarter wave transmission line) is included inside the power amplifier, not only a method and apparatus for calculating power based on voltages of a front end and rear end of the transmission line but also an electronic device including the apparatus and an electronic device using the method is included in embodiments of the disclosure.

Referring to FIG. 8, an exemplary functional configuration of the electronic device 810 is illustrated. The electronic device 810 may include an antenna unit 811, a filter unit 812, a Radio Frequency (RF) processing unit 813, and a control unit 814.

The antenna unit 811 may include a plurality of antennas. The antenna performs functions for transmitting and receiving signals through a radio channel. The antenna may include a radiator formed on a substrate (e.g., a PCB). The antenna may radiate an up-converted signal on the radio channel or obtain a signal radiated by another device. Each antenna may be referred to as an antenna element or an antenna device. In some embodiments, the antenna unit 811 may include an antenna array in which a plurality of antenna elements constitute an array. The antenna unit 811 may be electrically coupled to the filter unit 812 through RF signal lines. The antenna unit 811 may be mounted on a PCB including a plurality of antenna elements. The PCB may include a plurality of RF signal lines to couple each antenna element and a filter of the filter unit 812. The RF signal lines may be referred to as a feeding network. The antenna unit 811 may provide a received signal to the filter unit 812 or may radiate the signal provided from the filter unit 812 into the air. An antenna of the structure according to an embodiment of the disclosure may be included in the antenna unit 811,

According to various embodiments, the antenna unit 811 may include at least one antenna module having a dual-polarized antenna. The dual-polarized antenna may be, for example, a cross-pol (x-pol) antenna. The dual-polarized antenna may include two antenna elements corresponding to different polarizations. For example, the dual-polarized antenna may include a first antenna element having a polarization of +45° and a second antenna element having a polarization of -45°. It is obvious that the polarization may be formed of other polarizations orthogonal to each other, in addition to +45° and -45°. Each antenna element may be coupled to a feeding line, and may be electrically coupled to the filter unit 812, the RF processing unit 813, and the control unit 814 to be described below.

According to an embodiment, the dual-polarized antenna may be a patch antenna (or a micro-strip antenna). Since the dual-polarized antenna has a form of a patch antenna, it may be easily implemented and integrated as an array antenna. Two signals having different polarizations may be input to respective antenna ports. Each antenna port corresponds to an antenna element. For high efficiency, it is required to optimize a relationship between a co-pol characteristic and a cross-pol characteristic between the two signals having the different polarizations. In the dual-polarized antenna, the co-pol characteristic indicates a characteristic for a specific polarization component and the cross-pol characteristic indicates a characteristic for a polarization component different from the specific polarization component.

The filter unit 812 may perform filtering to transmit a signal of a desired frequency. The filter unit 812 may perform a function for selectively identifying a frequency by forming a resonance. In some embodiments, the filter unit 812 may structurally form the resonance through a cavity including a dielectric. In addition, in some embodiments, the filter unit 812 may form a resonance through elements which form inductance or capacitance. In addition, in some embodiments, the filter unit 812 may include a Bulk Acoustic Wave (BAW) filter or a Surface Acoustic Wave (SAW) filter. The filter unit 812 may include at least one of a band pass filter, a low pass filter, a high pass filter, and a band reject filter. That is, the filter unit 812 may include RF circuits for obtaining a signal of a frequency band for transmission or a frequency band for reception. The filter unit 812 according to various embodiments may electrically couple the antenna unit 811 and the RF processing unit 813 to each other.

The RF processing unit 813 may include a plurality of RF paths. The RF path may be a unit of a path through which a signal received through an antenna or a signal radiated through the antenna passes. At least one RF path may be referred to as an RF chain. The RF chain may include a plurality of RF elements. The RF elements may include an amplifier, a mixer, an oscillator, a Digital-to-Analog Converter (DAC), an Analog-to-Digital Converter (ADC), or the like. For example, the RF processing unit 813 may include an up converter which up-converts a digital transmission signal of a baseband to a transmission frequency, and a DAC which converts the converted digital transmission signal into an analog RF transmission signal. The converter and the DAC constitute a transmission path in part. The transmission path may further include a Power Amplifier (PA) or a coupler (or a combiner). In addition, for example, the RF processing unit 813 may include an ADC which converts an analog RF reception signal into a digital reception signal and a down converter which converts the digital reception signal into a digital reception signal of a baseband. The ADC and the down converter constitute a reception path in part. The reception path may further include a Low-Noise Amplifier (LNA) or a coupler (or a divider). RF parts of the RF processing unit may be implemented on a PCB. The antennas and the RF parts of the RF processing unit may be implemented on the PCB, and filters may be repeatedly fastened between one PCB and another PCB to constitute a plurality of layers.

A power amplifier and sensor having a structure according to an embodiment of the disclosure may be included in the RF processing unit 813 of FIG. 8. That is, the RF processing unit 813 may be understood as part of the RF chain of the disclosure. In addition, a specific-length transmission line having a structure according to an embodiment of the disclosure may exist inside a specific power amplifier (e.g., a Doherty power amplifier), and thus may be included in the RF processing unit 813. However, the disclosure is not limited thereto, and the specific-length transmission line may be disposed to a region which connects the RF processing unit 813 and the antenna unit 811. A length of the transmission line may be associated with a wavelength of a signal passing through the transmission line.

The control unit 814 may provide overall control to the electronic device 810. The control unit 814 may include various modules for performing communication. The control unit 814 may include at least one processor such as a modem.

The control unit 814 may include modules for digital signal processing. For example, the control unit 814 may include a modem. In data transmission, the control unit 814 generates complex symbols by encoding and modulating a transmission bit-stream. In addition, for example, in data reception, the control unit 814 restores a reception bit-stream by demodulating and decoding a baseband signal. The control unit 814 may perform functions of a protocol stack required in a communication standard.

An ADC & Modem having a structure according to an embodiment of the disclosure may be included in the control unit 814 of FIG. 8.

The functional configuration of the electronic device 810 is described in FIG. 8 as a device capable of utilizing an apparatus and method according to various embodiments. However, the example of FIG. 8 is only an exemplary configuration for utilizing the apparatus and method according to various embodiments of the disclosure described with reference to FIG. 1 to FIG. 7, and embodiments of the disclosure are not limited to components of the device of FIG. 8. Therefore, in an electronic device including a specific-length transmission line between a power amplifier and an antenna or including a specific-length transmission line inside the power amplifier, a method of measuring power based on voltages of a front end and rear end of the transmission line, an apparatus using the method, or an electronic device including the apparatus using the method may also be understood as an embodiment of the disclosure.

In addition, the disclosure is not limited to the structure illustrated in FIG. 1 to FIG. 7. For example, although power is calculated by using a representative value calculated based on the first voltage and the second voltage in FIG. 1 to FIG. 7 in the disclosure, the power may also be calculated based on a representative value of voltages measured in another portion (e.g., a third connection portion, a fourth connection portion, etc.). Accordingly, the electronic device may include a plurality of power amplifiers, a plurality of specific-length transmission lines, or a plurality of sensors.

Methods based on the embodiments disclosed in the claims and/or specification of the disclosure may be implemented in hardware, software, or a combination of both.

When implemented in software, computer readable recording medium for storing one or more programs (i.e., software modules) may be provided. The one or more programs stored in the computer readable recording medium are configured for execution performed by one or more processors in the electronic device. The one or more programs include instructions for allowing the electronic device to execute the methods based on the embodiments disclosed in the claims and/or specification of the disclosure.

The program (i.e., the software module or software) may be stored in a random access memory, a non-volatile memory including a flash memory, a read only memory (ROM), an electrically erasable programmable read only memory (EEPROM), a magnetic disc storage device, a compact disc-ROM (CD-ROM), digital versatile discs (DVDs) or other forms of optical storage devices, and a magnetic cassette. Alternatively, the program may be stored in a memory configured in combination of all or some of these storage media. In addition, the configured memory may be plural in number.

Further, the program may be stored in an attachable storage device capable of accessing the electronic device through a communication network such as the Internet, an Intranet, a local area network (LAN), a wide LAN (WLAN), or a storage area network (SAN) or a communication network configured by combining the networks. The storage device may have access to a device for performing an embodiment of the disclosure via an external port. In addition, an additional storage device on a communication network may have access to the device for performing the embodiment of the disclosure.

In the aforementioned specific embodiments of the disclosure, a component included in the disclosure is expressed in a singular or plural form according to the specific embodiment proposed herein. However, the singular or plural expression is selected properly for a situation proposed for the convenience of explanation, and thus the various embodiments of the disclosure are not limited to a single or a plurality of components. Therefore, a component expressed in a plural form may also be expressed in a singular form, or vice versa.

While the disclosure has been shown and described with reference to certain preferred embodiments thereof, it will be understood by those skilled in the art that various changes in form and details may be made therein without departing from the scope of the disclosure as defined by the appended claims. Therefore, the scope of the disclosure is defined not by the detailed description thereof but by the appended claims.

## Claims

1. A method performed by an electronic device, the method comprising:

obtaining, by at least one sensor (250), a first voltage of a first signal at a first point (231) of a first connection member for connecting a first power amplifier (211) of a power amplifier and a transmission line of the power amplifier;
obtaining, by the at least one sensor (250), a second voltage of a second signal at a second point of a second connection member for connecting the transmission line (220) and an antenna (240), wherein a second power amplifier (212) of the power amplifier is electrically connected to a point of the second connection member; and calculating a power of the second signal output by the power amplifier, based on the first voltage and the second voltage,

wherein a length of the transmission line (220) is based on a wavelength of the second signal.

2. The method of claim 1, wherein the length of the transmission line is substantially a quarter of the wavelength of the second signal.

3. The method of claim 1,

wherein the power amplifier is a Doherty power amplifier,
wherein the transmission line is disposed inside the Doherty power amplifier, and
wherein the length of the transmission line is substantially a quarter of the wavelength of the second signal.

4. The method of claim 1, wherein a phase difference between a first phase of the first signal and a second phase of the second signal is about 180°.

5. The method of claim 1, wherein the power is calculated based on an average value of the first voltage and the second voltage.

6. The method of claim 5, wherein the average value is an arithmetic average value of the first voltage and the second voltage.

7. The method of claim 1, wherein the power is calculated based on at least one of a maximum value, a median value, or a weight of each of the first voltage and the second voltage.

8. An electronic device (200) in a wireless communication system, the electronic device (200) comprising:

a power amplifier including a first power amplifier (211), a second power amplifier (212) and a transmission line (220);
an antenna (240);
a first connection member and a second connection member;
at least one sensor (250); and
at least one processor electrically coupled to the at least one sensor (250),
wherein the at least one processor is configured to:

obtain a first voltage of a first signal at a first point (231) of the first connection member for connecting the first power amplifier and the transmission line (220) using the at least one sensor (250),
obtain a second voltage of a second signal at a second point of the second connection member for connecting the transmission line (220) and the antenna (240) using the at least one sensor (250), wherein the second power amplifier (212) is electrically connected to a point of the second connection member, and
calculate a power of the second signal output by the power amplifier, based on the first voltage and second voltage obtained by the at least one sensor (250), and

wherein a length of the transmission line (220) is based on a wavelength of the second signal.

9. The electronic device (200) of claim 8, wherein the length of the transmission line (220) is substantially a quarter of the wavelength of the second signal.

10. The electronic device (200) of claim 8,

wherein the power amplifier is a Doherty power amplifier,
wherein the transmission line is disposed inside the Doherty power amplifier, and
wherein the length of the transmission line is substantially a quarter of the wavelength of the second signal.

11. The electronic device (200) of claim 8, wherein a phase difference between a first phase of the first signal and a second phase of the second signal is about 180°.

**12.** The electronic device (200) of claim 8, wherein the at least one processor is configured to calculate the power based on an average value of the first voltage and the second voltage.

**13.** The electronic device (200) of claim 12, wherein the average value is an arithmetic average value of the first voltage and the second voltage.

**14.** The electronic device (200) of claim 8, wherein the at least one processor is configured to calculate the power based on at least one of a maximum value, a median value, or a weight of each of the first voltage and the second voltage.

**15.** An electronic device (810) in a wireless communication system, the electronic device (810) comprising:

a plurality of radio frequency, RF, chains;
a plurality of antennas (240) corresponding to the plurality of RF chains;
at least one sensor (250); and
at least one processor electrically coupled to the at least one sensor (250),
wherein at least one RF chain of the plurality of RF chains includes:

a power amplifier including a first power amplifier (211), a second power amplifier (212) and a transmission line (220), and
a first connection member and a second connection member,
wherein the at least one processor is configured to:

obtain a first voltage of a first signal at a first point (231) of the first connection member for connecting the first power amplifier and the transmission line using the at least one sensor (250), and
obtain a second voltage of a second signal at a second point of the second connection member for connecting at least one antenna (240) among the plurality of antennas and the transmission line using the at least one sensor (250), wherein the second power amplifier (212) is electrically connected to a point of the second connection member,
calculate a power of the second signal output by the power amplifier, based on the first voltage and second voltage obtained by the at least one sensor (250), and

wherein a length of the transmission line is based on a wavelength of the second signal.

**Patentansprüche**

**1.** Verfahren, das durch eine elektronische Vorrichtung durchgeführt wird, wobei das Verfahren Folgendes umfasst:

Erhalten, durch mindestens einen Sensor (250), einer ersten Spannung eines ersten Signals an einem ersten Punkt (231) eines ersten Verbindungselements zum Verbinden eines ersten Leistungsverstärkers (211) eines Leistungsverstärkers und einer Übertragungsleitung des Leistungsverstärkers;
Erhalten, durch den mindestens einen Sensor (250), einer zweiten Spannung eines zweiten Signals an einem zweiten Punkt eines zweiten Verbindungselements zum Verbinden der Übertragungsleitung (220) und einer Antenne (240), wobei ein zweiter Leistungsverstärker (212) des Leistungsverstärkers elektrisch mit einem Punkt des zweiten Verbindungselements verbunden ist; und
Berechnen einer Leistung des zweiten Signals, die von dem Leistungsverstärker ausgegeben wird, basierend auf der ersten Spannung und der zweiten Spannung,
wobei eine Länge der Übertragungsleitung (220) auf einer Wellenlänge des zweiten Signals basiert.

**2.** Verfahren nach Anspruch 1, wobei die Länge der Übertragungsleitung im Wesentlichen ein Viertel der Wellenlänge des zweiten Signals beträgt.

**3.** Verfahren nach Anspruch 1,

wobei der Leistungsverstärker ein Doherty-Leistungsverstärker ist,
wobei die Übertragungsleitung innerhalb des Doherty-Leistungsverstärkers angeordnet ist, und
wobei die Länge der Übertragungsleitung im Wesentlichen ein Viertel der Wellenlänge des zweiten Signals beträgt.

**4.** Verfahren nach Anspruch 1, wobei eine Phasendifferenz zwischen einer ersten Phase des ersten Signals und einer zweiten Phase des zweiten Signals etwa 180° beträgt.

**5.** Verfahren nach Anspruch 1, wobei die Leistung basierend auf einem Durchschnittswert der ersten Spannung und der zweiten Spannung berechnet wird.

**6.** Verfahren nach Anspruch 5, wobei der Durchschnittswert ein arithmetischer Durchschnittswert der ersten Spannung und der zweiten Spannung ist.

**7.** Verfahren nach Anspruch 1, wobei die Leistung basierend auf mindestens einem von einem Maximalwert, einem Medianwert oder einer Gewichtung von jeder der ersten Spannung und der zweiten Spannung berechnet wird.

**8.** Elektronische Vorrichtung (200) in einem drahtlosen Kommunikationssystem, wobei die elektronische Vorrichtung (200) Folgendes umfasst:

> einen Leistungsverstärker, der einen ersten Leistungsverstärker (211), einen zweiten Leistungsverstärker (212) und eine Übertragungsleitung (220) enthält;
> eine Antenne (240);
> ein erstes Verbindungselement und ein zweites Verbindungselement;
> mindestens einen Sensor (250); und
> mindestens einen Prozessor, der elektrisch mit dem mindestens einen Sensor (250) gekoppelt ist,
> wobei der mindestens eine Prozessor konfiguriert ist zum:

>> Erhalten einer ersten Spannung eines ersten Signals an einem ersten Punkt (231) des ersten Verbindungselements zum Verbinden des ersten Leistungsverstärkers und der Übertragungsleitung (220) unter Verwendung des mindestens einen Sensors (250),
>> Erhalten einer zweiten Spannung eines zweiten Signals an einem zweiten Punkt des zweiten Verbindungselements zum Verbinden der Übertragungsleitung (220) und der Antenne (240) unter Verwendung des mindestens einen Sensors (250), wobei der zweite Leistungsverstärker (212) elektrisch mit einem Punkt des zweiten Verbindungselements verbunden ist, und
>> Berechnen einer Leistung des zweiten Signals, die von dem Leistungsverstärker ausgegeben wird, basierend auf der ersten Spannung und der zweiten Spannung, die von dem mindestens einen Sensor (250) erhalten werden, und

> wobei eine Länge der Übertragungsleitung (220) auf einer Wellenlänge des zweiten Signals basiert.

**9.** Elektronische Vorrichtung (200) Anspruch 8, wobei die Länge der Übertragungsleitung (220) im Wesentlichen ein Viertel der Wellenlänge des zweiten Signals beträgt.

**10.** Elektronische Vorrichtung (200) nach Anspruch 8,

> wobei der Leistungsverstärker ein Doherty-Leistungsverstärker ist,
> wobei die Übertragungsleitung innerhalb des Doherty-Leistungsverstärkers angeordnet ist, und
> wobei die Länge der Übertragungsleitung im Wesentlichen ein Viertel der Wellenlänge des zweiten Signals beträgt.

**11.** Elektronische Vorrichtung (200) Anspruch 8, wobei eine Phasendifferenz zwischen einer ersten Phase des ersten Signals und einer zweiten Phase des zweiten Signals etwa 180° beträgt.

**12.** Elektronische Vorrichtung (200) nach Anspruch 8, wobei der mindestens eine Prozessor konfiguriert ist, um die Leistung basierend auf einem Durchschnittswert der ersten Spannung und der zweiten Spannung zu berechnen.

**13.** Elektronische Vorrichtung (200) Anspruch 12, wobei der Durchschnittswert ein arithmetischer Durchschnittswert der ersten Spannung und der zweiten Spannung ist.

**14.** Elektronische Vorrichtung (200) nach Anspruch 8, wobei der mindestens eine Prozessor konfiguriert ist, um die Leistung basierend auf mindestens einem von einem Maximalwert, einem Medianwert oder einer Gewichtung von jeder der ersten Spannung und der zweiten Spannung zu berechnen.

**15.** Elektronische Vorrichtung (810) in einem drahtlosen Kommunikationssystem, wobei die elektronische Vorrichtung (810) Folgendes umfasst:

  eine Vielzahl von Hochfrequenzketten, HF-Ketten;
  eine Vielzahl von Antennen (240), die der Vielzahl von HF-Ketten entspricht;
  mindestens einen Sensor (250); und
  mindestens einen Prozessor, der elektrisch mit dem mindestens einen Sensor (250) gekoppelt ist,
  wobei mindestens eine HF-Kette der Vielzahl von HF-Ketten Folgendes beinhaltet:

    einen Leistungsverstärker, der einen ersten Leistungsverstärker (211), einen zweiten Leistungsverstärker (212) und eine Übertragungsleitung (220) enthält, und
    ein erstes Verbindungselement und ein zweites Verbindungselement,
    wobei der mindestens eine Prozessor konfiguriert ist zum:

      Erhalten einer ersten Spannung eines ersten Signals an einem ersten Punkt (231) des ersten Verbindungselements zum Verbinden des ersten Leistungsverstärkers und der Übertragungsleitung unter Verwendung des mindestens einen Sensors (250), und
      Erhalten einer zweiten Spannung eines zweiten Signals an einem zweiten Punkt des zweiten Verbindungselements zum Verbinden mindestens einer Antenne (240) aus der Vielzahl von Antennen und der Übertragungsleitung unter Verwendung des mindestens einen Sensors (250), wobei der zweite Leistungsverstärker (212) elektrisch mit einem Punkt des zweiten Verbindungselements verbunden ist, Berechnen einer Leistung des zweiten Signals, die von dem Leistungsverstärker ausgegeben wird, basierend auf der ersten Spannung und der zweiten Spannung, die von dem mindestens einen Sensor (250) erhalten werden, und

    wobei eine Länge der Übertragungsleitung auf einer Wellenlänge des zweiten Signals basiert.

**Revendications**

**1.** Procédé exécuté par un dispositif électronique, le procédé comprenant :

  obtenir, par au moins un capteur (250), une première tension d'un premier signal à un premier point (231) d'un premier élément de connexion pour connecter un premier amplificateur de puissance (211) d'un amplificateur de puissance et une ligne de transmission de l'amplificateur de puissance ;
  obtenir, par l'au moins un capteur (250), une deuxième tension d'un deuxième signal en un deuxième point d'un deuxième élément de connexion pour connecter la ligne de transmission (220) et une antenne (240), dans lequel un deuxième amplificateur de puissance (212) de l'amplificateur de puissance est électriquement connecté à un point du deuxième élément de connexion ; et
  calculer une alimentation du deuxième signal émis par l'amplificateur de puissance, en se basant sur la première tension et la deuxième tension,
  dans lequel une longueur de la ligne de transmission (220) est basée sur une longueur d'onde du deuxième signal.

**2.** Procédé de la revendication 1, dans lequel la longueur de la ligne de transmission est sensiblement égale à un quart de la longueur d'onde du deuxième signal.

**3.** Procédé de la revendication 1,

  dans lequel l'amplificateur de puissance est un amplificateur de puissance Doherty,
  dans lequel la ligne de transmission est disposée à l'intérieur de l'amplificateur de puissance Doherty, et
  dans lequel la longueur de la ligne de transmission est sensiblement égale à un quart de la longueur d'onde du deuxième signal.

**4.** Procédé de la revendication 1, dans lequel une différence de phase entre une première phase du premier signal et une deuxième phase du deuxième signal est d'environ 180°.

**5.** Procédé de la revendication 1, dans lequel l'alimentation est calculée en se basant sur une valeur moyenne de la première tension et de la deuxième tension.

**6.** Procédé de la revendication 5, dans lequel la valeur moyenne est une valeur moyenne arithmétique de la première tension et de la deuxième tension.

**7.** Procédé de la revendication 1, dans lequel l'alimentation est calculée sur la base au moins d'une valeur maximale, d'une valeur médiane ou d'un poids de chacune de la première tension et de la deuxième tension.

**8.** Dispositif électronique (200) dans un système de communication sans fil, le dispositif électronique (200) comprenant :

un amplificateur de puissance comprenant un premier amplificateur de puissance (211), un deuxième amplificateur de puissance (212) et une ligne de transmission (220) ;
une antenne (240) ;
un premier élément de connexion et un deuxième élément de connexion ;
au moins un capteur (250) ; et
au moins un processeur électriquement couplé à l'au moins un capteur (250),
dans lequel l'au moins un processeur est configuré pour :

obtenir une première tension d'un premier signal à un premier point (231) du premier élément de connexion pour connecter le premier amplificateur de puissance et la ligne de transmission (220) à l'aide de l'au moins un capteur (250),
obtenir une deuxième tension d'un deuxième signal à un deuxième point du deuxième élément de connexion pour connecter la ligne de transmission (220) et l'antenne (240) à l'aide de l'au moins un capteur (250), dans lequel le deuxième amplificateur de puissance (212) est électriquement connecté à un point du deuxième élément de connexion, et
calculer une puissance du deuxième signal émis par l'amplificateur de puissance, sur la base de la première tension et de la deuxième tension obtenues par l'au moins un capteur (250), et

dans lequel une longueur de la ligne de transmission (220) est basée sur une longueur d'onde du deuxième signal.

**9.** Dispositif électronique (200) de la revendication 8, dans lequel la longueur de la ligne de transmission (220) est sensiblement égale à un quart de la longueur d'onde du deuxième signal.

**10.** Dispositif électronique (200) de la revendication 8,

dans lequel l'amplificateur de puissance est un amplificateur de puissance Doherty,
dans lequel la ligne de transmission est disposée à l'intérieur de l'amplificateur de puissance Doherty, et
dans lequel la longueur de la ligne de transmission est sensiblement égale à un quart de la longueur d'onde du deuxième signal.

**11.** Dispositif électronique (200) de la revendication 8, dans lequel une différence de phase entre une première phase du premier signal et une deuxième phase du deuxième signal est d'environ 180°.

**12.** Dispositif électronique (200) de la revendication 8, dans lequel l'au moins un processeur est configuré pour calculer la puissance sur la base d'une valeur moyenne de la première tension et de la deuxième tension.

**13.** Dispositif électronique (200) de la revendication 12, dans lequel la valeur moyenne est une valeur moyenne arithmétique de la première tension et de la deuxième tension.

**14.** Dispositif électronique (200) de la revendication 8, dans lequel l'au moins un processeur est configuré pour calculer la puissance sur la base au moins d'une valeur maximale, d'une valeur médiane, ou d'un poids de chacune de la première tension et de la deuxième tension.

**15.** Dispositif électronique (810) dans un système de communication sans fil, le dispositif électronique (810) comprenant :

une pluralité de chaînes de radiofréquence, RF ;
une pluralité d'antennes (240) correspondant à la pluralité de chaînes RF ;

au moins un capteur (250) ; et
au moins un processeur couplé électriquement à l'au moins un capteur (250),
dans lequel au moins une chaîne RF de la pluralité de chaînes RF comprend :

un amplificateur de puissance comprenant un premier amplificateur de puissance (211), un deuxième amplificateur de puissance (212) et une ligne de transmission (220), et
un premier élément de connexion et un deuxième élément de connexion,
dans lequel l'au moins un processeur est configuré pour :

obtenir une première tension d'un premier signal à un premier point (231) du premier élément de connexion pour connecter le premier amplificateur de puissance et la ligne de transmission à l'aide de l'au moins un capteur (250), et
obtenir une deuxième tension d'un deuxième signal à un deuxième point du deuxième élément de connexion pour connecter au moins une antenne (240) parmi la pluralité de antennes et la ligne de transmission à l'aide de l'au moins un capteur (250), dans lequel le deuxième amplificateur de puissance (212) est connecté électriquement à un point du deuxième élément de connexion,
calculer une puissance du deuxième signal émis par l'amplificateur de puissance, sur la base de la première tension et de la deuxième tension obtenues par l'au moins un capteur (250), et

dans lequel la longueur de la ligne de transmission est basée sur la longueur d'onde du deuxième signal.

FIG.1

FIG.2

300

310  331        320        332        340

PA      T/L      Antenna

341

r
θ₀

FIG.3A

FIG.3B

FIG.3C

FIG.4

FIG.5

FIG.6

FIG.7

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 100680211 B1

- US 20150116039 A1